# EUROPÄISCHE PATENTSCHRIFT

(11) **EP 1 317 020 B1**
(45) Veröffentlichungstag und Bekanntmachung des Hinweises auf die Patenterteilung: **21.06.2006**
(21) Anmeldenummer: 02450246.0
(22) Anmeldetag: 28.10.2002
(51) Int. Cl.: H01R 12/04, H01R 4/64

(54) **Kontaktierung von Leiterplatten bzw. Schaltungsträgern**
Contacting of printed boards with corresponding supports
Mise en contact de circuits imprimés avec leur support

(30) Priorität: 12.11.2001 AT 17792001
(43) Veröffentlichungstag der Anmeldung: 04.06.2003
(73) Patentinhaber: Siemens AG Österreich, 1210 Wien (AT)
(72) Erfinder: Petricek, Martin, 2020 Hollabrunn (AT)
(74) Vertreter: Matschnig, Franz

(56) Entgegenhaltungen:
- US-A- 5 759 049
- US-A- 5 786 989
- US-B1- 6 303 874

## Beschreibung

Die Erfindung betrifft ein elektrisches Gerät mit zumindest einem Schaltungsträger, welcher eine Bestückungsseite und eine Lötseite aufweist, wobei an dem Schaltungsträger ein mit zumindest einer Leiterbahn der Lötseite elektrisch verbundenes Kontaktelement aufgebracht ist, welches eine Kontaktfläche zur elektrischen Kontaktierung einer anderen zumindest abschnittsweise der Lötseite gegenüberliegenden Gerätekomponente aufweist.

Elektrische Geräte der oben genannten Art sind in großer Zahl bekannt geworden. Die Schaltungsträger dieser Geräte sind abschnittsweise durch Bohrungen von Lötaugen durchbrochen, wobei elektrische Bauelemente auf der Bestückungsseite des Schaltungsträgers angeordnet sind, und die Anschlüsse der Bauelemente durch die Bohrungen der Lötaugen gesteckt und auf der Lötseite mit einem Leiterzug verlötet werden.

Aus der US 5 786 989 A ist ein elektrisches Gerät der eingangs genannten Art bekannt geworden. Das bekannte Gerät weist einen Schaltungsträger auf, auf welchem auf einer Lötseite ein Kontaktierungselement aufgebracht ist. Durch das Kontaktierungselement ist der Schaltungsträger elektrisch mit einem der Lötseite gegenüberliegenden Rahmen des Gerätes verbunden.

Ein Problem, das sich bei den bekannten elektrischen Geräten immer wieder stellt besteht darin, dass auf der Bestückungsseite aufgebrachte Bauteile zwar automatisch auf der Lötseite mit dem Schaltungsträger bzw. der Leiterplatte verlötet werden können, aber für den Fall, dass eine elektrische Verbindung zu einem anderen Montageelement vorgesehen ist an der Lötseite eine elektrische Kontaktierung zu dem anderen Montageelement händisch angebracht werden muss. D. h. bei der Herstellung bekannter elektrischer Geräten ist zusätzlich zu den automatisierten Lötvorgang ein weiterer, händischer Lötvorgang notwendig, um eine elektrische Verbindung zwischen dem Schaltungsträger und einem weiteren Montagelement oder einem geerdeten Grundgerät herzustellen. Der händische Lötvorgang kann die Produktionskosten elektrischer Geräte wesentlich verteuern. Darüber hinaus wird der produktionstechnische Ablauf durch das händische Verlöten einer Kontaktierung mit der Lötseite des Schaltungsträgers verkompliziert.

Es ist daher eine Aufgabe der Erfindung, ein elektrisches Gerät zu schaffen, welcher die oben genannten Nachteile überwindet.

Diese Aufgabe wird mit einem elektrischen Gerät der eingangs genannten Art erfindungsgemäß dadurch gelöst, dass das Kontaktelement auf der Bestückungsseite aufgebracht ist und in einer Kontaktierungsposition, in welcher das Kontaktelement elektrisch über seine Kontaktfläche mit der anderen Gerätekomponente verbunden ist, das Kontaktelement die Ebene des Schaltungsträgers durchsetzt.

Es ist eine Verdienst der Erfindung, dass durch die Anordnung des Kontaktelementes auf der Bestückungsseite des Schaltungsträgers die Verlötung des Kontaktelementes auf dem Schaltungsträger vollautomatisch erfolgen kann.

Vorteilhafterweise weist der Schaltungsträger eine Ausnehmung auf, durch welche das Kontaktelement zumindest abschnittsweise von der Bestückungsseite auf die Lötseite geführt ist.

Um eine einfache Montage zu gewährleisten, kann ein Stift vorgesehen sein, welcher den Schaltungsträger und die andere Gerätekomponente in einem zusammengebauten Zustand des elektrischen Gerätes verbindet und einen im wesentlichen zylinderförmigen Grundkörper sowie einen an den Grundkörper anschließenden, mit diesem konzentrisch angeordneten zylinderförmigen Aufsatz mit einem kleineren Durchmesser als der Grundkörper aufweist, wobei der zylinderförmige Aufsatz mit der weiteren Gerätekomponente verschraubbar und die Ausnehmung in dem Schaltungsträger von dem Stift durchsetzt sowie das Kontaktelement bei der Montage durch den Stift in die Kontaktierungsposition bringbar und fixierbar ist.

In einer günstigen Ausführungsform der Erfindung kann ein Gehäuse vorgesehen sein, welches eine Abdeckung aufweist, die aus einem elektrisch nicht leitenden Kunststoff gefertigt ist, wobei die Abdeckung eine der Ausnehmung gegenüberliegende Öffnung aufweisen kann, durch welche der Stift einführbar ist.

In einer anderen ebenfalls sehr vorteilhaften Variante der Erfindung einen kann die Abdeckung einen die Ausnehmung in einem zusammengebauten Zustand des elektrischen Gerätes abschnittsweise durchsetzenden hohlen Dorn aufweisen, der zur Aufnahme eines Verbindungselementes eingerichtet ist, welches die Abdeckung mit dem Schaltungsträger und einer weiteren Gerätekomponente in einem zusammengebauten Zustand verbindet, wobei das Kontaktelement bei der Montage durch den Dorn in die Kontaktierungsposition bringbar ist.

Günstigerweise weist das Kontaktelement eine Fixierungsausnehmung auf, mittels welcher es von dem Verbindungselement oder dem Stift in der Kontaktierungsposition fixierbar ist.

Weitere Vorteile lassen sich dadurch erzielen, dass der Dorn und/oder das Verbindungselement oder der Stift aus einem elektrisch nicht leitenden Kunststoff gefertigt sind.

Die Erfindung samt weiteren Vorteilen wird im folgenden anhand einiger nicht einschränkender Ausführungsbeispiele näher erläutert, welche in der Zeichnung dargestellt sind. In dieser zeigen schematisch:
Fig. 1 einen Schaltungsträger und ein erfindungsgemäßes Kontaktelement;
Fig. 1a das Kontaktierungselement aus Fig. 1 im näheren Detail;
Fig. 2 den Schaltungsträger mit montiertem Kontaktelement aus Fig. 1 und eine Abdeckung in einer explodierten Darstellung;
Fig. 3 den Schaltungsträger und die Abdeckung aus Fig. 2 in montiertem Zustand in einer perspektivischen Ansicht;
Fig. 4 den Schaltungsträger und die Abdeckung aus Fig. 3 in einer Draufsicht;
Fig. 5 einen Schnitt entlang der Linie A-A in Fig. 4
   und
Fig. 6 eine Querschnitt durch eine weitere Variante der Erfindung.

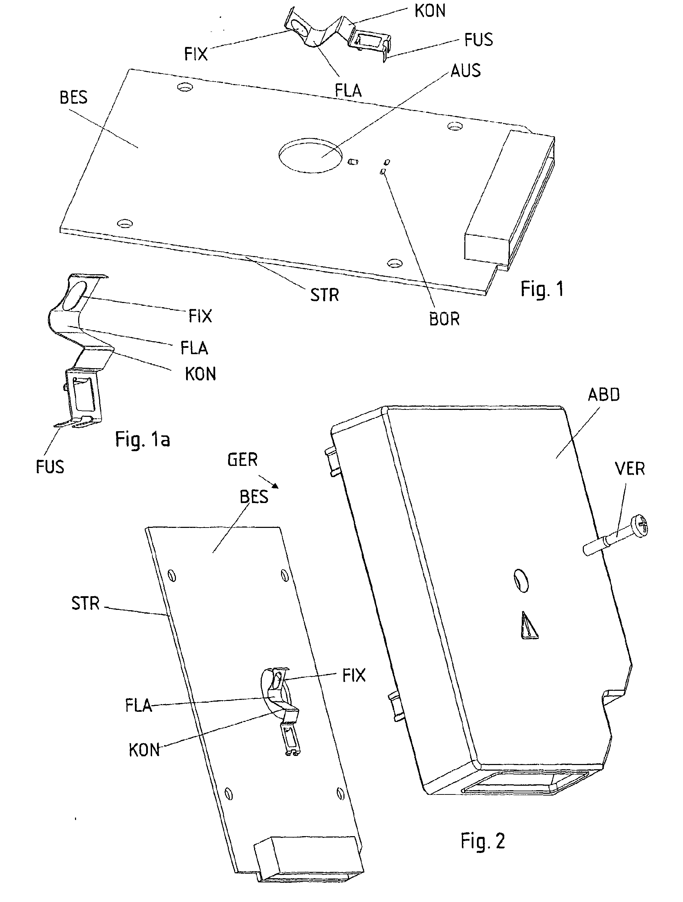

Gemäß Fig. 1, Fig. 1a und Fig. 2 weist ein erfindungsgemäßes elektrisches Gerät GER einen oder mehrere Schaltungsträger STR, beispielsweise Leiterplatten, auf. Die hier dargestellte Leiterplatte ist auf der Bestückungsseite BES mit - hier aus darstellerischen Gründen nicht gezeigten - Bauelementen bestückt. Durch Bohrungen BOR in dem Schaltungsträger sind die elektrischen Anschlüsse ANS der Bauelemente gesteckt und mit einer Lötseite LOT der Leiterplatte verbunden und dort mit einem Leiterzug verlötet. Auf der Bestückungsseite BES des Schaltungsträgers STR ist ein Kontaktierungselement KON vorgesehen, dessen elektrische Anschlüsse ANS ebenfalls durch Bohrungen des Schaltungsträgers STR auf die Lötseite LOT geführt und dort mit dem Leitungszug verlötet sind.

Das Kontaktierungselement KON weist, wie auch für andere Bauelemente üblich, zur Befestigung an dem Schaltungsträger STR Füßchen FUS auf mit, denen es auf der Lötseite LOT mit dem Schaltungsträger STR verlötet bzw. elektrisch mit einem Leiterzug verbunden werden kann. Da das Kontaktierungselement KON, so wie andere Bauelemente, auf der Bestückungsseite BES aufgebracht wird, kann der Lötvorgang vollautomatisch durchgeführt werden.

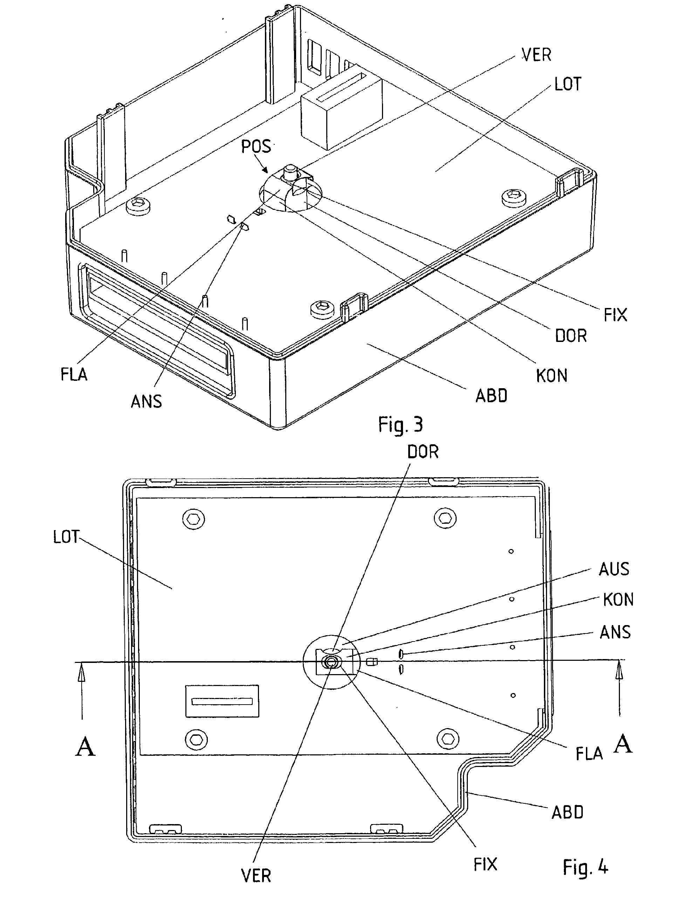

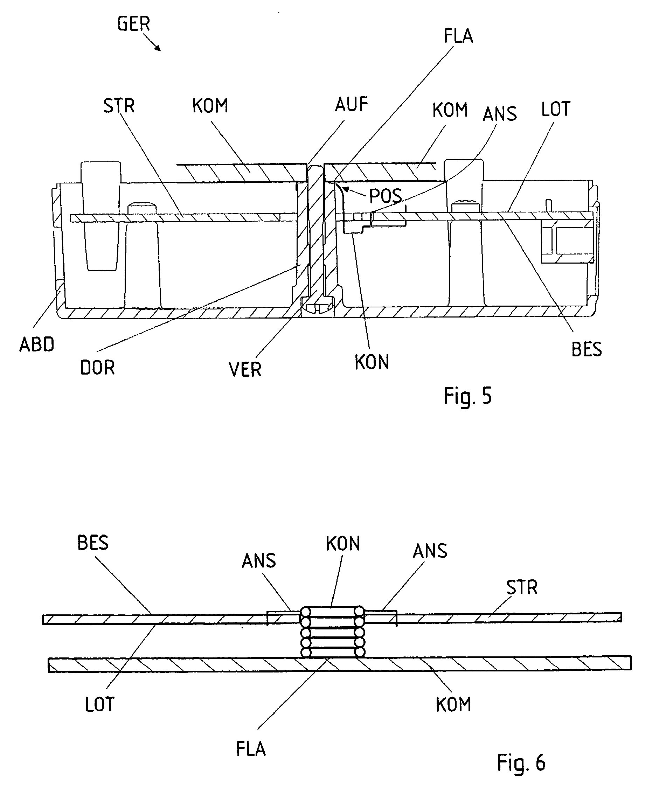

Durch eine Ausnehmung AUS in dem Schaltungsträger STR kann das Kontaktierungselement KON bei der Montage durch den Schaltungsträger STR von der Bestückungsseite BES auf die Lötseite geführt werden. Hierzu kann eine Abdeckung ABD eines Gehäuses einen hohlen Dorn DOR oder Stift aufweisen, der eine Kontaktierungsfläche FLA des Kontaktelementes KON, die sich in einem nicht montierten Zustand auf Seite der Bestückungsseite BES befinden kann, bei der Montage auf die Lötseite drückt. D. h. bei der hier gezeigten Variante der Erfindung wird erst bei der Endmontage der Leiterplatte durch den in der Abdeckung ABD mitgeformten Dorn oder Stift abschnittsweise das Kontaktelement KON und somit die Kontaktfläche FLA an die Lötseite LOT bzw. in eine Kontaktierungsposition POS gebracht (Fig. 3, Fig. 4), wobei in der Kontaktierungsposition POS die Ebene des Schaltungsträgers STR von dem Kontaktelement KON durchsetzt und der Schaltungsträger STR mit der weiteren Gerätekomponente KOM elektrisch verbunden wird. Aus Sicherheitsgründen sind hierbei die Abdeckung ABD, der Dorn DOR und das Verbindungselement VER bevorzugterweise aus einem elektrisch nicht leitenden Kunststoff hergestellt. Es ist jedoch nicht unbedingt erforderlich, dass das elektrische Gerät ein Gehäuse aufweist, so kann der Schaltungsträger STR beispielsweise in einem Rahmen angeordnet sein. Derartige Geräte sind ebenfalls in großer Zahl bekannt geworden.

Bei Zusammenbau des Gerätes GER wird die Kontaktfläche FLA in die Kontaktierungsposition POS d. h. in Kontakt mit einem elektrisch leitenden Abschnitt der anderen Gerätekomponente KOM gebracht, wodurch eine elektrische Verbindung zwischen dieser Komponente und dem Schaltungsträger STR hergestellt wird. D. h. in der Kontaktierungsposition POS stehen der Schaltungsträger STR bzw. die Leiterplatte elektrisch mit einer weiteren Gerätekomponente über die Kontaktfläche FLA bzw. das Kontaktelement KON in Verbindung.

Das Kontaktierungselement KON kann, darüber hinaus an seinem der Kontaktierungsfläche FLA benachbarten Endbereich eine Fixierungsausnehmung FIX aufweisen, die in einer Montageendposition über einer Aufnahme des Dorns DOR für ein den Schaltungsträger STR mit der weiteren Gerätekomponente KOM mechanisch verbindendes Verbindungselement VER, beispielsweise eine Schraube, zu liegen kommt und mit dieser Aufnahme bündig abschließt (Fig. 5).

Dadurch kann eine Fixierung des Kontaktelementes KON bzw. der Kontaktfläche FLA durch das Verbindungselement VER in der gewünschten Endposition erreicht werden, wodurch sich eine sehr gute elektrische Verbindung zwischen dem Schaltungsträger STR bzw. der Leiterplatte und der anderen Gerätekomponente KOM erzielen lässt.

Handelt es sich bei dem Verbindungselement VER um eine Schraube so kann die Aufnahme AUF an ihren inneren Seitenflächen vorteilhafterweise mit dem Gewindegang der Schraube zusammenwirkendes Gewinde aufweisen. D. h. für den Fall, dass das Verbindungselement eine Schraube ist kann die Leiterplatte durch Verschrauben der Abdeckung mit einer elektrisch leitfähigen Montageplatte, z. B. ein geerdetes Grundgerät, eine elektrisch leitende Gehäuserückwand o. ä, elektrisch kontaktiert und verbunden werden.

Über das Verbindungselement VER können somit die Abdeckung ABD und der Schaltungsträger STR mit der weiteren Gerätekomponente KOM verbunden werden. Die der Lötseite LOT des Schaltungsträgers STR zugewandte Seite der weiteren Gerätekomponente KOM ist zumindest abschnittsweise aus einem elektrisch leitenden Material hergestellt.

Eine andere Variante der Erfindung besteht darin, dass anstelle des Dorns DOR ein Stift, der gleichzeitig als Verbindungselement VER dient durch eine Öffnung der Abdeckung ABD eingeführt wird, die der Ausnehmung AUS in dem Schaltungsträger STR gegenüberliegt. Dieser Stift bzw. dieses Verbindungselement VER kann beispielsweise einen im wesentlichen zylinderförmigen Grundkörper und einen an den Grundkörper anschließenden, mit diesem konzentrisch angeordneten zylinderförmigen Aufsatz mit einem kleineren Durchmesser als der Grundkörper aufweisen. Der zylinderförmige Aufsatz kann ein Schraubgewinde aufweisen, wobei der Stift mit der Aufnehmung AUF der weiteren Gerätekomponente KOM verschraubt werden kann. Anders gesagt entspricht der Stift in seiner äußeren Form im wesentlichen dem Dorn DOR der Abdeckung ABD mit einer in dessen Aufnahme eingeführten Schraube, weshalb hier auf eine gesonderte Darstellung des Stiftes verzichtet wird. Ein Unterschied zwischen diesen beiden Ausführungsformen besteht darin, dass bei Verwendung eines Stiftes die Anordnung eines Dornes DOR in die Abdeckung ABD entfallen kann, wodurch sich die Herstellung der Abdeckung ABD etwas vereinfachen lässt.

Bei Verwendung eines Stiftes anstelle des Dornes DOR und der Schraube, kann der dem aus dem Dorn DOR herausragenden Stück der Schraube entsprechende zylindrische Aufsatz durch die Fixierungsausnehmung FIX geführt werden, wobei der Stift mit der Aufnahme AUF der weiteren Gerätekomponente KOM verschraubt werden kann.

Natürlich sind neben den oben beschriebenen Ausführungsformen auch andere Varianten der Erfindung denkbar, so kann beispielsweise das Kontaktierungselement KON seitlich an dem Schaltungsträger STR angeordnet und von der Bestückungsseite BES an die Lötseite LOT geführt sein, wobei in diesem Fall keine Ausnehmung AUS in dem Schaltungsträger STR notwendig ist.

Auch können für den Fall, dass für das elektrische Gerät kein Gehäuse vorgesehen ist, der Schaltungsträger STR und die weitere Gerätekomponente ebenfalls durch den oben beschriebenen Stift miteinander verbunden sein. Diese Ausführungsform unterscheidet sich von der oben beschriebenen lediglich dadurch, dass keine Abdeckung ABD vorhanden ist, durch welche der Stift hindurch geführt ist.

Das Kontaktierungselement KON kann gemäß Fig. 6 auch als Feder ausgeführt sein, wobei die Feder auf der Bestückungsseite BES aufgebracht und auf der Lötseite LOT mit dem Schaltungsträger STR verlötet ist. In einem montierten Zustand verbindet das Kontaktierungselement KON, in diesem Fall eine Spiralfeder, den Schaltungsträger STR elektrisch mit der weiteren Gerätekomponente bzw. einer elektrisch leitenden Fläche der weiteren Gerätekomponente.

## Patentansprüche

1. Elektrisches Gerät (GER) mit zumindest einem Schaltungsträger (STR), welcher eine Bestückungsseite (BES) und eine Lötseite (LOT) aufweist, wobei an dem Schaltungsträger (STR) ein mit zumindest einer Leiterbahn der Lötseite (LOT) elektrisch verbundenes Kontaktelement (KON) aufgebracht ist, welches eine Kontaktfläche (FLA) zur elektrischen Kontaktierung einer anderen zumindest abschnittsweise der Lötseite gegenüberliegenden Gerätekomponente (KOM) aufweist, **dadurch gekennzeichnet, dass** das Kontaktelement (KOM) auf der Bestückungsseite (BES) aufgebracht ist und in einer Kontaktierungsposition (POS), in welcher das Kontaktelement (KON) elektrisch über seine Kontaktfläche (FLA) mit der anderen Gerätekomponente (KOM) verbunden ist, das Kontaktelement (KON) die Ebene des Schaltungsträgers (STR) durchsetzt.

2. Elektrisches Gerät nach Anspruch 1, **dadurch gekennzeichnet, dass** der Schaltungsträger (STR) eine Ausnehmung (AUS) aufweist, durch welche das Kontaktelement (KON) zumindest abschnittsweise von der Bestückungsseite (BES) auf die Lötseite (LOT) geführt ist.

3. Elektrisches Gerät nach Anspruch 2, **dadurch gekennzeichnet, dass** ein Stift vorgesehen ist, welcher den Schaltungsträger (STR) und die andere Gerätekomponente (KOM) in einem zusammengebauten Zustand des elektrischen Gerätes verbindet und einen im wesentlichen zylinderförmigen Grundkörper sowie einen an den Grundkörper anschließenden, mit diesem konzentrisch angeordneten zylinderförmigen Aufsatz mit einem kleineren Durchmesser als der Grundkörper aufweist, wobei der zylinderförmige Aufsatz mit der weiteren Gerätekomponente (KOM) verschraubbar und die Ausnehmung (AUS) in dem Schaltungsträger (STR) von dem Stift durchsetzt sowie das Kontaktelement (KON) bei der Montage durch den Stift in die Kontaktierungsposition (POS) bringbar und fixierbar ist.

4. Elektrisches Gerät nach einem der Ansprüche 1 bis 3, **dadurch gekennzeichnet, dass** ein Gehäuse vorgesehen ist, welches eine Abdeckung (ABD) aufweist, die aus einem elektrisch nicht leitenden Kunststoff gefertigt ist.

5. Elektrisches Gerät nach Anspruch 4, **dadurch gekennzeichnet, dass** die Abdeckung (ABD) eine der Ausnehmung (AUS) gegenüberliegende Öffnung aufweist, durch welche der Stift einführbar ist.

6. Elektrisches Gerät nach Anspruch 4, **dadurch gekennzeichnet, dass** die Abdeckung (ABD) einen die Ausnehmung (AUS) in einem zusammengebauten Zustand des elektrischen Gerätes abschnittsweise durchsetzenden hohlen Dorn (DOR) aufweist, der zur Aufnahme eines Verbindungselementes (VER) eingerichtet ist, welches die Abdeckung mit dem Schaltungsträger (STR) und einer weiteren Gerätekomponente (KOM) in einem zusammengebauten Zustand verbindet, wobei das Kontaktelement (KON) bei der Montage durch den Dorn (DOR) in die Kontaktierungsposition (POS) bringbar ist.

7. Elektrisches Gerät nach einem der Ansprüche 3 bis 6, **dadurch gekennzeichnet, dass** das Kontaktelement (KON) eine Fixierungsausnehmung (FIX) aufweist, mittels welcher es durch das Verbindungselement (VER) oder den Stift in der Kontaktierungsposition (POS) fixierbar ist.

8. Elektrisches Gerät nach Anspruch 6 oder 7, **dadurch gekennzeichnet, dass** der Dorn (DOR) aus einem elektrisch nicht leitenden Kunststoff gefertigt ist.

9. Elektrisches Gerät nach einem der Ansprüche 4 bis 7, **dadurch gekennzeichnet, dass** das Verbindungselement (VER) oder der Stift aus einem elektrisch nicht leitenden Kunststoff gefertigt sind.

## Claims

1. An electrical apparatus (GER) comprising at least one circuit board (STR) which has a component side (BES) and a soldering side (LOT), wherein a contact element (KON) electrically connected to at least one conducting path on the soldering side (SOL) is present on said circuit board (STR), which contact element has a contact surface (FLA) for effecting electrical bonding to another device component (KOM) disposed at least in part on the side opposite the soldering side, **characterized in that** said contact element (KOM) is placed on the component side (BES), and, in a bonding position (POS) in which the said contact element (KON) is electrically bonded via its contact surface (FLA) to the other device component (KOM), the contact element (KON) penetrates the plane of the circuit board (STR).

2. An electrical apparatus as defined in Claim 1, **characterized in that** said circuit board (STR) has a recess (AUS), through which said contact element (KON) is guided at least in part from the component side (BES) to the soldering side (LOT).

3. An electrical apparatus as defined in Claim 2, **characterized in that** a pin is provided, which, in an assembled state of the electrical apparatus, connects said circuit board (STR) to said other device component (KOM) and has a substantially cylindrical base portion and also a cylindrical upper portion concentrically adjoining said base portion and having a smaller diameter than said base portion, wherein said cylindrical upper portion can be screwed to said other device component (KOM), and said recess (AUS) in said circuit board (STR) is penetrated by said pin, and, during assembly, said contact element (KON) can be brought into the bonding position (POS), and fixed in position, by said pin.

4. An electrical apparatus as defined in any one of claims 1 to 3, **characterized in that** a casing is provided which has a cover (ABD) of an electrically non-conducting plastics material.

5. An electrical apparatus as defined in claim 4, **characterized in that** said cover (ABD) has an opening opposite said recess (AUS), through which opening said pin can be inserted.

6. An electrical apparatus as defined in claim 4, **characterized in that** said cover (ABD) has a hollow mandrel (DOR) which, in an assembled state of the electrical apparatus, passes in part through said recess (AUS) and is adapted to accommodate a connecting element (VER) which, in an assembled state, connects said cover to said circuit board (STR) and said other device component (KOM), and said contact element (KON) can, during assembly, be brought into the bonding position (POS) by said mandrel (DOR).

7. An electrical apparatus as defined in any one of claims 3 to 6, **characterized in that** said contact element (KON) has a mounting recess (FIX), by means of which it can be fixed in the bonding position (POS) by said connecting element (VER) or by said pin.

8. An electrical apparatus as defined in claim 6 or claim 7, **characterized in that** said mandrel (DOR) is made of an electrically non-conducting plastics material.

9. An electrical apparatus as defined in any one of claims 4 to 7, **characterized in that** said connecting element (VER) or said pin is made of an electrically non-conducting plastics material.

## Revendications

1. Appareil électrique (GER) avec au moins un support de circuit (STR) qui comporte un côté équipement (BES) et un côté soudure (LOT), dans lequel un élément de contact (KON) raccordé électriquement au moins à une voie conductrice du côté soudure (LOT) est installé sur le support de circuit (STR), lequel élément de contact comporte une surface de contact (FLA) pour la mise en contact électrique d'un autre composant de l'appareil (KOM) placé en face du côté soudure au moins par sections, **caractérisé en ce que** l'élément de contact (KON) est installé sur le côté équipement (BES) et dans une position de mise contact (POS), dans laquelle l'élément de contact (KON) est raccordé électriquement par le biais de sa surface de contact (FLA) à l'autre composant de l'appareil (KOM), l'élément de contact (KON) traversant le niveau du support de circuit (STR).

2. Appareil électrique selon la revendication 1, **caractérisé en ce que** le support de circuit (STR) comporte une cavité (AUS), à travers laquelle l'élément de contact (KON) est introduit au moins par sections à partir du côté équipement (BES) sur le côté soudure (LOT).

3. Appareil électrique selon la revendication 2, **caractérisé en ce qu'**une broche est prévue, qui relie le support de circuit (STR) et l'autre composant de l'appareil (KOM) dans un état assemblé de l'appareil électrique et comporte un corps principal essentiellement en forme de cylindre ainsi qu'une garniture se raccordant au corps principal, en forme de cylindre et disposée avec celui-ci de manière concentrique, avec un diamètre plus petit que le corps principal, dans lequel la garniture en forme de cylindre peut être vissée avec l'autre composant de l'appareil (KOM) et que la cavité (AUS) dans le support de circuit (STR) est traversée par la broche et que lors du montage, l'élément de contact (KON) pouvant être amené et fixé dans la position de mise en contact (POS) par la broche.

4. Appareil électrique selon l'une des revendications 1 à 3, **caractérisé en ce qu'**un boîtier est prévu, qui comporte un couvercle (ABD) fabriqué dans un matériau synthétique non-conducteur d'électricité.

5. Appareil électrique selon la revendication 4, **caractérisé en ce que** le couvercle (ABD) comporte une ouverture placée en face de la cavité (AUS), à travers laquelle la broche peut être introduite.

6. Appareil électrique selon la revendication 4, **caractérisé en ce que** le couvercle (ABD) comporte une broche (DOR) creuse traversant par sections la cavité (AUS) dans un état assemblé de l'appareil électrique, laquelle broche est installée pour le logement d'un élément de liaison (VER), qui relie le couvercle au support de circuit (STR) et à un autre composant d'appareil (KOM) dans un état monté, dans lequel l'élément de contact (KON) peut être amené lors du montage dans la position de mise en contact (POS) par la broche (DOR).

7. Appareil électrique selon l'une des revendications 3 à 6, **caractérisé en ce que** l'élément de contact (KON) comporte une cavité de fixation (FIX) qui permet de fixer celui-ci par l'élément de liaison (VER) ou la broche dans la position de mise en contact (POS).

8. Appareil électrique selon la revendication 6 ou 7, **caractérisé en ce que** la broche (DOR) est fabriquée dans un matériau synthétique non-conducteur d'électricité.

9. Appareil électrique selon l'une des revendications 4 à 7, **caractérisé en ce que** l'élément de liaison (VER) ou la broche (DOR) sont fabriqués dans un matériau synthétique non-conducteur d'électricité.
